# EUROPEAN PATENT APPLICATION

(11) **EP 4 716 062 A1**
(43) Date of publication of application: **25.03.2026**
(21) Application number: 25198085.0
(22) Date of filing: 26.08.2025
(51) Int. Cl.: H02J 7/80, H01M 10/42, H01M 10/48

(54) **BATTERY MANAGEMENT SYSTEM, BATTERY MANAGEMENT METHOD, AND PROGRAM**

(30) Priority: 18.09.2024 JP 2024161016
(71) Applicant: Casio Computer Co., Ltd., Tokyo 151-8543 (JP)
(72) Inventor: Yamada, Shunsuke, Hamura-shi, Tokyo, 205-8555 (JP)
(74) Representative: Grünecker Patent- und Rechtsanwälte PartG mbB

(57) **Abstract**

A battery management system (110) includes: a charging controller (112) that controls charging of a secondary battery (102); a voltage sensor (121) that detects a voltage of the secondary battery; and a controller (113) that estimates an estimated range to which a battery level of the secondary battery belongs among multiple battery level ranges. Based on the detected voltage in a charging state among multiple charging states of the charging controller (112), the controller (113) tentatively determines a tentative range to which the battery level belongs among the multiple battery level ranges. Based on comparison between the tentative range and a past estimated range estimated in a past, the controller (113) estimates a current estimated range that is the estimated range of this time.

## Description

### TECHNICAL FIELD

The present disclosure relates to a battery management system, a battery management method, and a program.

### DESCRIPTION OF RELATED ART

Japanese Patent Publication No. 2019-000295 describes a vacuum cleaner that informs the user of the battery level of a secondary battery by light-emitting modes. The voltage of a secondary battery usually changes as the battery level increases or decreases. The voltage of the secondary battery also changes even if the battery level remains the same when the charging state switches from a being-charged state to a not-charged state or vice versa.

The battery level (state of charge: SOC) of the secondary battery correlates with its voltage and can be primarily expressed as a function of voltage. The function of voltage when the secondary battery is in the being-charged state as the charging state is different from that in the not-charged state. Therefore, the battery level of the secondary battery can be estimated, based on information on the charging state and voltage. However, there may be a time lag between when the charging state is switched and when a controller recognizes the switching. During the time lag, the estimated charging state is different from the actual charging state, which leads to an error in the estimated battery level.

An object of the present disclosure is to provide a battery management system, a battery management method, and a program that allow accurate estimation of the battery level.

### SUMMARY OF THE INVENTION

According to an aspect of the present disclosure, a battery management system includes: a charging controller that controls charging of a secondary battery; a voltage sensor that detects a voltage of the secondary battery; and a controller that estimates an estimated range to which a battery level of the secondary battery belongs among multiple battery level ranges, wherein: based on the detected voltage in a charging state among multiple charging states of the charging controller, the controller tentatively determines a tentative range to which the battery level belongs among the multiple battery level ranges, and based on comparison between the tentative range and a past estimated range estimated in a past, the controller estimates a current estimated range that is the estimated range of this time.

### Advantageous Effects of Invention

According to the present disclosure, the battery level can be accurately estimated.

### BRIEF DESCRIPTION OF DRAWINGS

FIG. 1 is a block diagram of an electrical device that includes a battery management system of an embodiment.
FIG. 2 is a first part of a flowchart showing the procedure of a battery level estimation process performed by a controller.
FIG. 3 is a second part of the flowchart.
FIG. 4 is a third part of the flowchart.
FIG. 5 is a diagram for explaining an example of operations when the charging state is switched from the being-charged state to the not-charged state.
FIG. 6 is a diagram for explaining an example of operations when the charging state is switched from the not-charged state to the being-charged state.

### DETAILED DESCRIPTION

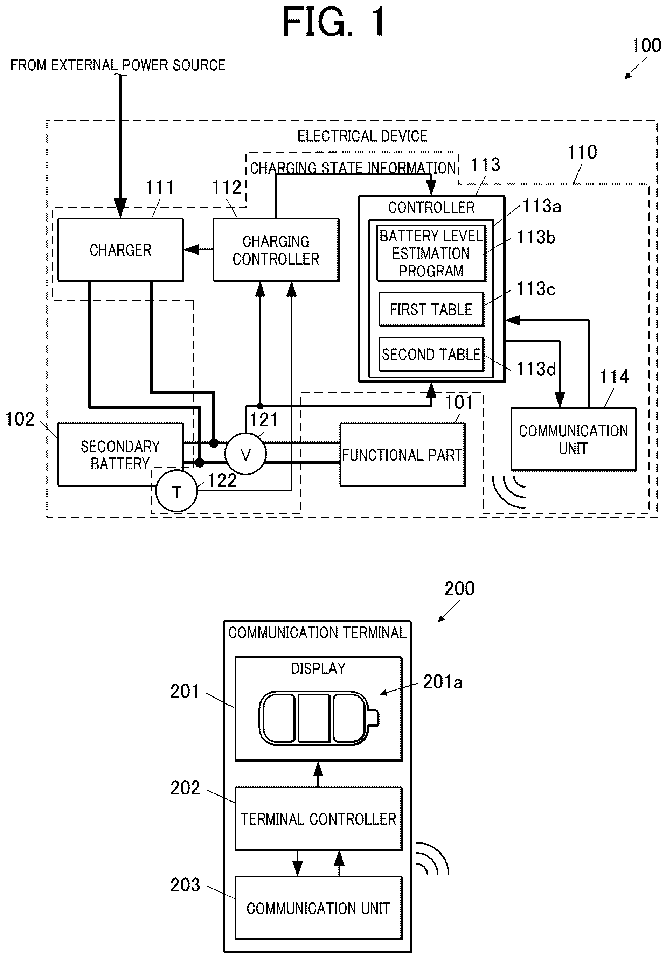

Hereinafter, an embodiment of the present disclosure is described in detail with reference to the figures. As illustrated in FIG. 1, a battery management system 110 of this embodiment is incorporated in an electrical device 100. The electrical device 100 includes a secondary battery 102 (e.g., a secondary battery such as a lithium-ion battery) and a functional part 101 that is powered by the secondary battery 102. The electrical device 100 is not limited to a specific device. Various kinds of devices can be applicable as the electrical device 100, such as a sensor device that detects specific physical quantities, a home electrical appliance, and a robot. The functional part 101 corresponds to an electronic or electrical device that performs part or all of the functions of the electrical device 100.

The battery management system 110 includes: a charger 111 that takes in power from an external power source and supplies charging power to the secondary battery 102; a charging controller 112 that controls charging of the secondary battery 102 via the charger 111; a controller 113 that estimates the battery level of the secondary battery 102; and a communication unit 114 that communicates with a communication terminal 200 regarding at least the battery level. The battery management system 110 further includes a voltage sensor 121 that detects the voltage of the secondary battery 102 and a temperature sensor 122 that detects the temperature of the secondary battery 102. The battery level corresponds to the state of charge (SOC), for example. The communication unit 114 is an example of a transmission unit that transmits information related to the estimated battery level to the outside. The charger 111 and/or the charging controller 112 may be constituted by dedicated hardware circuitry and realized by a processor performing a program. The controller 113 may be constituted by a dedicated controller and realized by a combination of a general-purpose processor and a program stored in a memory. The communication unit 114 may be configured as an independent communication module and may be a circuit integrated with the controller 113.

The secondary battery 102 is a lithium-ion secondary battery, for example. Various secondary batteries are applicable, such as a lithium polymer secondary battery and a nickel-metal hydride secondary battery. The charger 111 contactlessly takes in power by electromagnetism, namely without a contact between power lines. The charger 111 may take in power via cables (lines). The charger 111 charges the secondary battery 102 by the constant-current constant-voltage method. However, various other charging methods may be applied. When the secondary battery 102 in the not-charged state supplies power to the functional part 101 and so forth, a voltage drop occurs owing to the internal resistance of the secondary battery 102. On the other hand, in the being-charged state, the power is supplied from the external power source to the functional part 101 and so forth, and the secondary battery 102 does not discharge current, so that the voltage drop does not occur. Therefore, the voltage of the secondary battery 102 appears higher in the being-charged state than in the not-charged state.

The voltage sensor 121 sends detected values at least to the charging controller 112 and the controller 113. The temperature sensor 122 sends detected values at least to the charging controller 112.

The charging controller 112 controls switching of the charging states of the secondary battery 102. The charging states include: the being-charged state in which the secondary battery 102 is being charged by the charger 111: the charging-completed state in which the secondary battery 102 is fully charged and charging is stopped; the charging-error state in which charging is stopped owing to an error; and the not-charged state in which charging is not performed owing to a factor other than the full charge or an error. Specifically, the charging-error state corresponds to a state where charging is not performed owing to a malfunction, such as a case where charging is not started even in a chargeable state and a case where the temperature of the secondary battery 102 is abnormally high. When connection to the external power source cuts off in the being-charge state, the charging controller 112 switches the charging state to the not-charged state. When the power of the secondary battery 102 is consumed and its battery level is decreased by a predetermined degree from the charging-completed state, the charging controller 112 switches the charging state to the not-charged state. In the not-charged state, the charging controller 112 stops charging operation of the charger 111.

The full charge in the charging-completed state corresponds, specifically, to a state where the voltage of the secondary battery 102 has reached its end-of-charge voltage or a state where, after the end-of-charge voltage is reached, charging is switched to constant-current charging and the charging current is less than or equal to a predetermined value. The value of the end-of-charge voltage is set such that the secondary battery 102 is protected from overcharging. When the secondary battery 102 is in a standard temperature range, the end-of-charge voltage is set to a standard end-of-charge voltage (e.g., 4 V). When the secondary battery 102 is in a cautionary temperature range beyond the standard temperature range, the end-of-charge voltage is set to a high-temperature end-of-charge voltage (e.g., 3.9 V) different from the standard end-of-charge voltage. In the standard temperature range, the charging controller 112 switches the charging state to the charging-completed state when charging is completed at the standard end-of-charge voltage. In the cautionary temperature range, the charging controller 112 switches the charging state to the charging-completed state when charging is completed at the high-temperature end-of-charge voltage.

The charging controller 112 distinguishes the charging states of the secondary battery 102, based on detection signals of the voltage sensor 121, detection signals of the temperature sensor 122, state information of the charger 111 (e.g., information regarding the connection to a contactless power transmitter, information on input voltage), and so forth. The charging controller 112 notifies the user of the distinguished charging state by lighting modes of a light emission part, for example. The charging controller 112 also sends charging state information indicating the charging state to the controller 113. The charging state information may be signals or the like generated for the purpose of notifying the controller 113 of the charging state. Alternatively, the charging state information may be information or signals generated for other purposes. For example, signals for controlling the lighting modes of the light emission part may also serve as the charging state information. That is, the signal corresponding to the lighting mode, which indicates the charging state, may be sent to the controller 113 as the charging state information. The lighting may be substituted for output of other notification media, such as audio, vibration, or notification to mobile terminals, for example. When a longer time is needed to indicate a single charging state with the charging state information, a correspondingly longer delay time occurs for the controller 113 to distinguish the charging state based on the charging state information.

The controller 113 is a controller that operates in accordance with control programs stored in a storage 113a. The controller may be referred to as a microcomputer or a computer. The control programs include a program 113b of a battery level estimation process. The program 113b of the battery level estimation process may be stored in a portable storage medium and read and executed by the controller 113.

In the battery level estimation process, the controller 113 estimates the battery level of the secondary battery 102, based on the voltage of the secondary battery 102 and the charging state information. The controller 113 may be configured to irregularly execute the battery level estimation process in response to an external request from outside the battery management system 110 and send back the estimation result of the battery level. Specifically, the external request may be from the communication terminal 200 (e.g., a cell phone) that includes a display 201, a communication unit 203, and a terminal controller 202. The communication unit 114 can wirelessly communicate with the communication unit 203 of the terminal controller 202, for example. The display 201 of the communication terminal 200 may display the battery level. The terminal controller 202 requests information on the battery level from the controller 113 irregularly or at repetitive timings including variable intervals. For example, the communication terminal 200 regularly requests the information on the battery level only when the display 201 transitions to the battery level display screen. For another example, the communication terminal 200 requests the information in an interval between other prioritized processes performed by the communication terminal 200. Specifically, the communication terminal 200 may request the information at a predetermined interval in units of seconds, minutes, or hours, or at timings when the predetermined interval is changed. The minimum interval between the requests is shorter than a delay ΔT, which is described later. Based on the request, the controller 113 estimates the battery level and sends the information on the battery level to the terminal controller 202. Based on the information on the battery level, the terminal controller 202 updates the display of the battery level.

The controller 113 stores beforehand a first table 113c and a second table 113d that show the relation between the voltage of the secondary battery 102 and its battery level in the storage 113a. The first table 113c is a data table showing the relation between the voltage and the battery level in the not-charged state. The second table 113d is a data table showing the relation between the voltage and the battery level in the being-charged state. The first table 113c and the second table 113d may show the battery level by discrete values corresponding to multiple ranges for indicating to which range the battery level belongs. In this embodiment, the following three ranges are used as an example of multiple ranges of the battery level: the "first level" that is less than 33%; the "second level" that is greater than or equal to 33% and less than 67%; and the "third level" that is greater than or equal to 67%. The ranges different from these may be used. For example, four or more ranges may be used.

The first table 113c and the second table 113d show multiple ranges of voltage values corresponding to the above ranges of the battery level. At the same battery level, the voltage of the secondary battery 102 in the being-charged state is higher than that in the not-charged state. In the being-charged state, the output voltage of the charger 111 is equal to the voltage of the secondary battery 102. Therefore, in comparison of the voltage range corresponding to the third level in the first table 113c (e.g., 3.75 V or greater) with the voltage range corresponding to the third level in the second table 113d (e.g., 3.9 V or greater), the latter is higher, although there is a case where these two ranges partially overlap. The same applies to the voltage ranges corresponding to the second level (e.g., the range greater than or equal to 3.65 V and less than 3.75 V and the range greater than or equal to 3.85 V and less than 3.9 V) and the voltage ranges corresponding to the first level (e.g., the range less than 3.65 V and the range less than 3.85 V).

The controller 113 tentatively determines to which range the battery level of the secondary battery 102 belongs among the multiple ranges, based on the first table 113c and the second table 113d. Hereinafter, the tentatively determined range is referred to as the tentative range. The controller 113 then finally estimates to which range the battery level of the secondary battery 102 belongs among the multiple ranges. Hereinafter, the finally estimated range is referred to as the estimated range. The tentative range and the estimated range are any of the above ranges, specifically, the first level, the second level, or the third level. The display 201 may display the battery level using a symbol 201a. The symbol 201a may indicate to which range the battery level belongs among the above ranges.

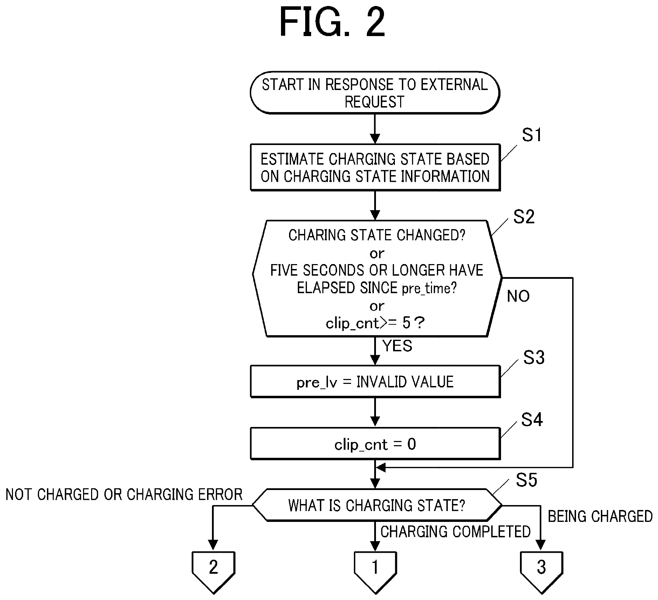

The controller 113 repetitively executes the battery level estimation process shown in FIG. 2 to FIG. 4, based on an external request (specifically, a request from the communication terminal 200). The external request may be from a higher-level controller. Among multiple times of the repetitively executed battery level estimation process, the process being currently executed is referred to as the current battery level estimation process, and the process executed immediately before the current process is referred to as the previous battery level estimation process. In FIG. 2 to FIG. 4, "cur0_lv" indicates the tentative range of the battery level that is tentatively estimated in the current process (any of the first to third levels) or represents a variable that stores the tentative range; "cur_lv" indicates the estimated range that is the estimation result of the current process (any of the first to third levels) or represents a variable that stores the estimated range; "pre_lv" indicates the previous estimated range that is the estimation result of the previous process (any of the first to third levels) or mainly represents a variable that stores the previous estimated range; "clip_cnt" is a variable that stores the consecutive number of times of a clip process, which is described later; "pre_time" is a variable that stores the time at which the previous estimated range was determined (or the time at which the previous estimated range was sent to the communication terminal 200); and "cur_vol" indicates the voltage of the secondary battery 102 obtained in the current battery level estimation process or represents a variable that stores the voltage. More specifically, "cur_vol" stores an average of voltages measured within a most recent predetermined period (e.g., one second). The battery level estimation process in FIG. 2 to FIG. 4 is an example of the battery management method for managing charging and the battery level of the secondary battery 102. The program 113b of the battery level estimation process causes the controller 113 as the computer to estimate the battery level.

As shown in FIG. 2, the controller 113 starts one time of the battery level estimation process in response to receiving a request for the battery level information of the secondary battery 102 from the communication terminal 200. When the process starts, the controller 113 estimates the charging state of the secondary battery 102, based on the charging state information of the charging controller 112 (step S1). When the charging states are switched, there is a time lag (delay) between when the charging states are actually switched and when the switching can be recognized. Therefore, when the charging states are switched, the charging state estimated in Step S1 may be the charging state before the switching. Herein, "when..." may specifically include a time period of several seconds (e.g., one to five seconds) after the event "..." occurs.

Next, the controller 113 determines whether any of the following is satisfied: (i) the charging state estimated in Step S1 of the current process is different from the previous charging state; (ii) a threshold period (e.g., five seconds) or longer has elapsed since "pre_time"; or (iii) "clip_cnt"is greater than or equal to a threshold number of times (e.g., five times) (step S2). When any of (i) to (iii) is satisfied (YES), the controller 113 proceeds to Step S3. When none of (i) to (iii) is satisfied (NO), the controller 113 proceeds to Step S5.

When proceeding to Step S3, the controller 113 performs a reset process for not executing the clip process described later (the process of setting the current estimated range to the previous estimated range). Specifically, in the reset process, the controller 113 writes an invalid value to "pre_lv" (Step S3). Next, the controller 113 sets "clip_cnt" to zero because the clip process is not executed (Step S4) and proceeds to Step S5.

In Step S5, the controller 113 performs a branching process according to the charging state estimated in Step S1. When the estimated charging state is the charging-completed state, the controller 113 writes "3" corresponding to the third level into "cur_lv" indicating the current estimated range (Step S6). The controller 113 then sends the current estimated range "cur_lv" to the communication terminal 200 (Step S51). The controller 113 then writes the value of "cur_lv" indicating the current estimated range into the variable of "pre_lv" indicating the previous estimated range for the next battery level estimation process (Step S52). The controller 113 updates "pre_time" to the current time (Step S53). The controller 113 then ends one time of the battery level estimation process.

In Steps S5 and S6, when the charging state is the charging-completed state, the estimated range "cur_lv" is determined to be the third level. Even if the temperature of the secondary battery 102 is within the cautionary temperature range and the charging is completed at a lower voltage, the estimated range "cur_lv" is determined to be the third level that includes the full charge, regardless of the voltage. Assume a configuration that determines the estimated range "cur_lv" based on the voltage. When the secondary battery 102 is in the cautionary temperature range, the end-of-charge voltage is set to a lower level, and the configuration may determine that the estimated range "cur_lv" is other than the third level at the time charging is completed. Such a case seems strange to the user because the battery is not fully charged even though charging has been completed. This embodiment, on the other hand, can avoid such a strange case for the user.

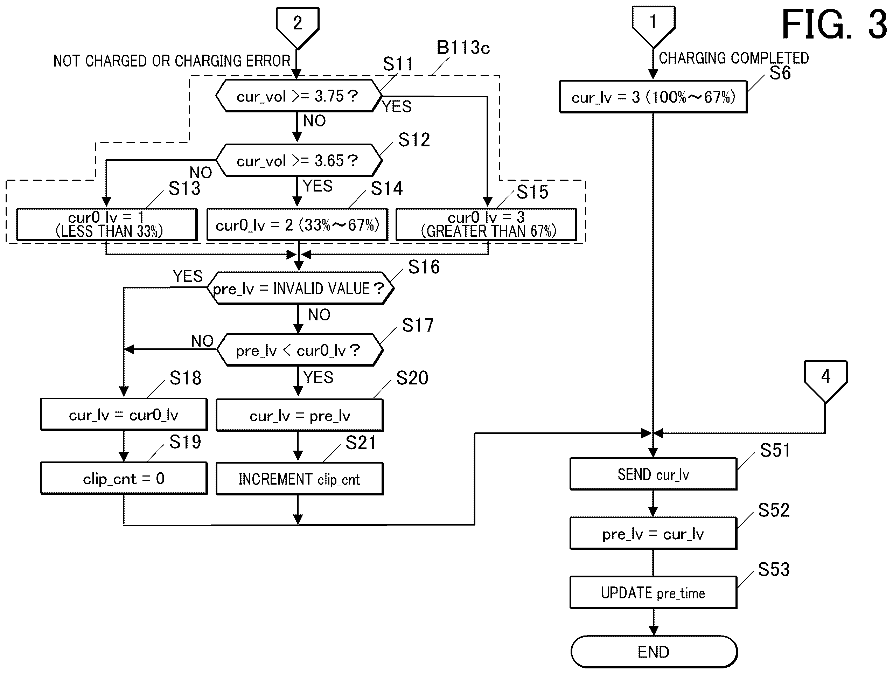

In the branching process of Step S5, when the estimated charging state is the not-charged state or the charging-error state, the controller 113 firstly determines the tentative range "cur0_lv" by using the voltage of the secondary battery 102 "cur_vol" and the first table 113c (Steps S11 to S15). The correspondence between the voltage ranges and the battery level ranges in the first table 113c is described above. The first table 113c may be stored by itself in the storage 113a as illustrated in FIG. 1 or may be stored as a program code like a block B113c illustrated in FIG. 3.

After determining the tentative range "cur0_lv", the controller 113 determines whether the previous estimated range "pre_lv" has been set to an invalid value by the reset process of Step S3 (Step S16). If NO in Step S16, the controller 113 compares the previous estimated range "pre_lv" with the tentative range "cur0_lv" (Step S17). As a result of these steps, if the previous estimated range "pre_lv" is an invalid value or if the tentative range "cur0_lv" is lower than or equal to the previous estimated range "pre_lv", the controller 113 does not execute the clip process described later. That is, the controller 113 determines the tentative range "cur0_lv" to be the current estimated range "cur_lv" (Step S18). Further, the controller 113 writes zero in "clip_cnt" because the clip process is not executed (Step S19) and proceeds to Step S51.

On the other hand, as a result of determinations in Steps S16 and S17, when the previous estimated range "pre_lv" is a valid value and the previous estimated range "pre_lv" is lower than the tentative range "cur0_lv", the controller 113 executes the clip process (Step S20). In the clip process, the value of the estimated range "cur_lv" is kept to the previous estimated range "pre_lv" to avoid an abnormal change in the value of the estimated range "cur_lv". In the not-charged state or the charging-error state, an increase of the battery level is an abnormal change. When such an abnormal change occurs, the clip process works effectively. In the clip process, the controller 113 determines the current estimated range "cur_lv" to be the same value as the previous estimated range "pre_lv" (Step S20). The controller 113 adds "1" to "clip_cnt", which indicates the consecutive number of times of the clip process (Step S21) and proceeds to Step S51.

The controller 113 executes the above-described Steps S51 to S53 and sends the current estimated range "cur_lv" determined in the current process to the communication terminal 200. The controller 113 then ends one time of battery level estimation process.

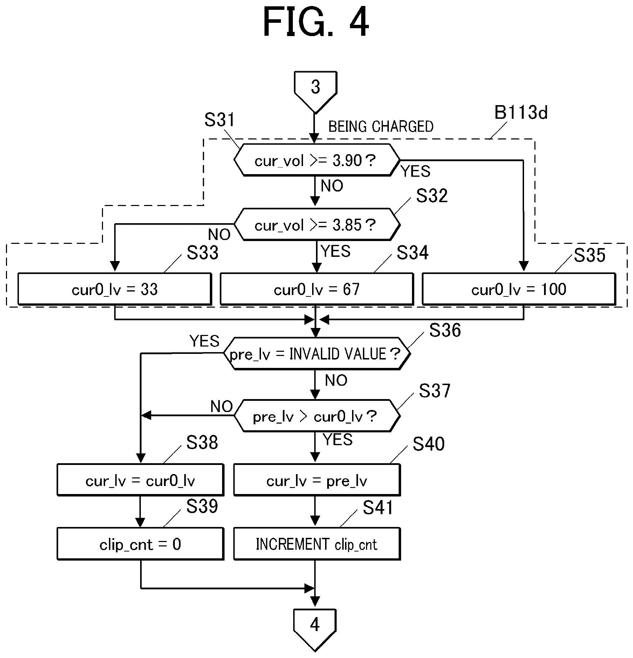

In the branching process of Step S5, when the estimated charging state is the being-charged state, the controller 113 firstly determines the tentative range "cur0_lv" by using the voltage of the secondary battery 102 "cur_vol" and the second table 113d (Steps S31 to S35). The correspondence between the voltage ranges and the battery level ranges in the second table 113d is described above. The second table 113d may be stored by itself in the storage 113a as illustrated in FIG. 1 or may be stored as a program code like a block B113d illustrated in FIG. 4.

After determining the tentative range "cur0_lv", the controller 113 determines whether the previous estimated range "pre_lv" has been set to an invalid value by the reset process of Step S3 (Step S36). If NO in Step S36, the controller 113 compares the previous estimated range "pre_lv" with the tentative range "cur0_lv" (Step S37). As a result of these steps, if the previous estimated range "pre_lv" is an invalid value or if the tentative range "cur0_lv" is greater than or equal to the previous estimated range "pre_lv", the controller 113 does not execute the clip process. That is, the controller 113 determines the tentative range "cur0_lv" to be the current estimated range "cur_lv" (Step S38). Further, the controller 113 writes zero in "clip_cnt" because the clip process is not executed (Step S39) and proceeds to Step S51.

On the other hand, as a result of determinations in Steps S36 and S37, when the previous estimated range "pre_lv" is a valid value and the tentative range "cur0_lv" is lower than the previous estimated range "pre_lv", the controller 113 executes the clip process (Step S40). The clip process is described above. In the being-charged state, a decrease in the battery level is an abnormal change. When such an abnormal change occurs, the clip process works effectively. In the clip process, the controller 113 determines the current estimated range "cur_lv" to be the same value as the previous estimated range "pre_lv" (Step S40). The controller 113 then adds "1" to "clip_cnt", which indicates the consecutive number of times of the clip process (Step S41), and proceeds to Step S51.

The controller 113 executes the above-described Steps S51 to S53 and sends the current estimated range "cur_lv" determined in the current process to the communication terminal 200. The controller 113 then ends one time of battery level estimation process.

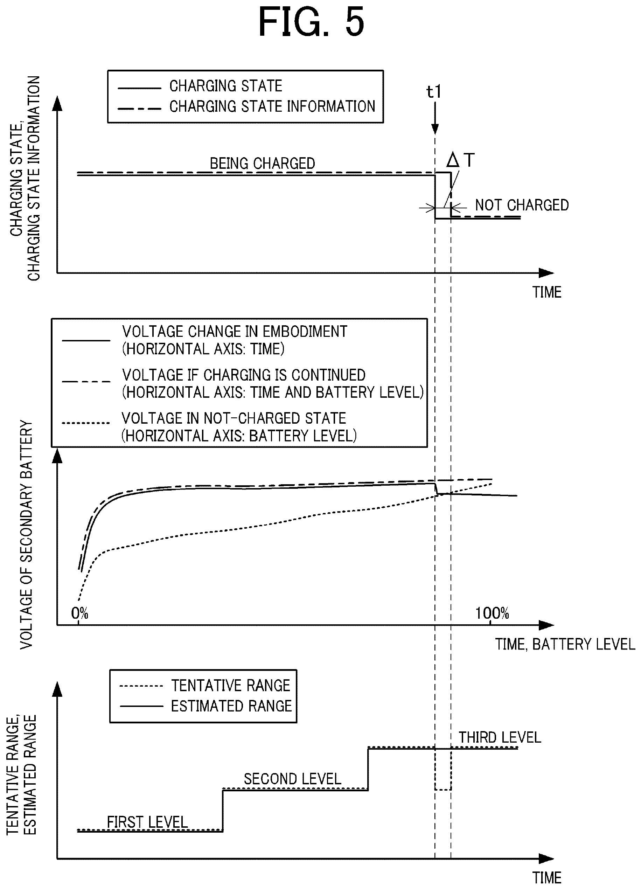

Next, the effect of the clip process is described with reference to FIG. 5. At timing t1 in FIG. 5, the charging state is switched from the being-charged state to the not-charged state. When the charging state is switched, there may be a delay ΔT until the switching can be recognized based on the charging state information. At timing t1 when the charging state is switched to the not-charged state, the voltage of the secondary battery 102 drops by one step. Although the charging state is actually the not-charged state, the controller 113 estimates that the charging state is the being-charged state and determines the tentative range "cur0_lv" based on the second table 113d. As a result, the controller 113 determines that the tentative range "cur0_lv" is the second level even though the actual battery level belongs to the range of the third level. In this embodiment, during the delay period ΔT, the controller 113 does not adopt the tentative range "cur0_lv" as the estimated range "cur_lv" but maintains "cur_lv" at the value of the previous estimated range "pre_lv" by executing the clip process of Step S40 in FIG. 4. Thus, when the charging states are switched, the controller 113 can avoid incorrect determination of the estimated range of the battery level and temporary incorrect display of the battery level symbol 201a.

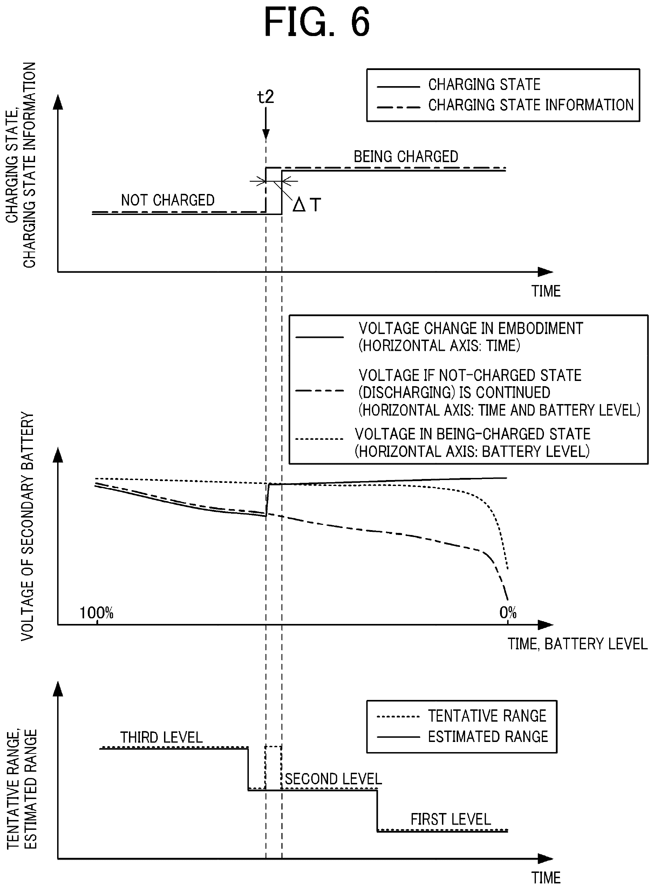

Next, the effect of the clip process is described with reference to FIG. 6. At timing t2 in FIG. 6, the charging state is switched from the not-charged state to the being-charged state. When the charging state is switched, there may be a delay ΔT until the switching can be recognized based on the charging state information. At timing t2 when the charging state is switched to the being-charged state, the voltage of the secondary battery 102 increases by one step. Although the charging state is actually the being-charged state, the controller 113 estimates that the charging state is the not-charged state and determines the tentative range "cur0_lv" based on the first table 113c. As a result, the controller 113 determines that the tentative range "cur0_lv" is the third level, even though the actual battery level belongs to the range of the second level. In this embodiment, during the delay period ΔT, the controller 113 does not adopt the tentative range "cur0_lv" as the estimated range "cur_lv" but maintains "cur_lv" at the value of the previous estimated range "pre_lv" by executing the clip process in Step S20 in FIG. 3. Thus, when the charging states are switched, the controller 113 can avoid wrong incorrect determination of the estimated range of the battery level and temporary incorrect display of the battery level symbol 201a.

As described above, according to the battery management system 110, the battery management method, and the program 113b of this embodiment, the following advantageous effects are obtained. As a prerequisite configuration, the charging controller 112 and the controller 113 are configured separately. The controller 113 determines the tentative range of the battery level, based on the charging state information and the voltage of the secondary battery 102. The controller 113 further determines the current estimated range, based on the comparison between the estimated range of the battery level in the past and the tentative range of the battery level. Accordingly, even if the charging state is wrongly estimated when the charging states are switched and this wrong estimation affects determination of the tentative range, the controller 113 can deal with the wrong estimation of the charging state and determine the estimated range. Thus, the battery level can be accurately estimated.

Further, the battery management system 110 of this embodiment includes the communication unit 114 that serves as a transmission unit that transmits the estimated range of the battery level to the outside of the battery management system 110. Based on the estimated range transmitted outside by the communication unit 114, the communication terminal 200 updates display of the symbol 201a on the display 201. By the determination process of the estimated range that deals with wrong estimation of the charging state, the battery management system 110 can avoid transmitting a wrongly estimated battery level and notifying the user of the wrong and odd estimation result of the battery level via the display 201.

In the above embodiment, the communication unit 114 that can communicate with the communication terminal 200 is described as an example of the transmission unit that transmits the estimated range to the outside. The configuration of the transmission unit is not limited to this. For example, the transmission unit may be configured to transmit signals indicating the estimated range of the battery level to a notification unit of the electrical device 100. The notification unit may notify the user of the battery level by various means, such as display, voice, or light. As a prerequisite configuration of the battery management system 110 of this embodiment, the controller 113 executes the battery level estimation process to determine the estimated range of the battery level, based on a request from outside the battery management system 110. According to the prerequisite configuration, the battery management system 110 does not unnecessarily execute the battery level estimation process and thereby saves power. On the other hand, according to the prerequisite configuration, the battery level estimation process is performed discontinuously, and the controller 113 has to discontinuously perform the process of estimating the charging state. As a result, when the charging state is switched, a delay tends to occur until the switching is recognized. Specifically, consider a case where the charging state is estimated, based on signal patterns of the light emission part indicating the charging state. If the estimation process is executed continuously, the signal of the light emission part that has been input in the previous estimation process can also be used in the current estimation process, so that the signal pattern can be quickly distinguished. On the other hand, if the estimation process is executed discontinuously, the signal in the previous process cannot be used in the current process, and it takes time to correctly distinguish the signal pattern. Therefore, for the above prerequisite configuration, the process of determining the estimated range that deals with the wrong estimation of the charging state is especially effective.

Further, according to the battery management system 110 of this embodiment, in the period estimated as the not-charged state based on the charging state information, the controller 113 compares the tentative range of the battery level (cur0_lv) with the past estimated range (pre_lv) (Step S17 in FIG. 3). When the past estimated range (pre_lv) is lower than the tentative range (cur0_lv), the controller 113 performs the clip process to set the current estimated range (cur_lv) to the past estimated range (pre_lv) (Step S20 in FIG. 3). By the clip process, the controller 113 can avoid wrong determination of the estimated range, which is likely to occur when the charging state is switched from the not-charged state to the being-charged state, as illustrated in FIG. 6.

Further, according to the battery management system 110 of this embodiment, in the period estimated as the being-charged state based on the charging state information, the controller 113 compares the tentative range of the battery level "cur0_lv" with the past estimated range "pre_lv" (Step S37 of FIG. 4). When the tentative range "cur0_lv" is lower than the past estimated range "pre_lv", the controller 113 executes the clip process to set the current estimated range "cur_lv" to the past estimated range "pre_lv" (Step S40 in FIG. 4). By the clip process, the controller 113 can avoid wrong determination of the estimated range, which is likely to occur when the charging state is switched from the being-charged state to the not-charged state, as illustrated in FIG. 5.

In the above embodiment, the past estimated range is the previous estimated range "pre_lv" as an example. However, various modifications are applicable. For example, when the resolution of the estimated range is low, the average value of the estimated ranges within a past predetermined period including the previous process may be used as the past estimated range. For another example, when the previous two times of the battery level estimation process were executed within a short period, the estimated range obtained in the process before the last process may be used as the past estimated range.

According to the battery management system 110 of this embodiment, the controller 113 further executes the reset process to avoid executing the clip process when any of conditions under which the reliability of the clip process is decreased is met (Step S3 in FIG. 2). As Step 2 in FIG. 2 shows, the conditions include (i) the estimated charging state is different from the last charging state, (ii) a threshold period or longer has elapsed after the last time the estimated range was determined, and (iii) the clip process has been consecutively performed by a threshold number of times (e.g., five times) or more. The reset process prevents execution of the clip process in a situation where the reliability of the clip process is decreased and thereby prevents wrong determination of the estimated range of the battery level. The threshold number of times of the clip process is determined such that wrong estimation of the battery level is reduced even when the charging state are switched in various ways, based on (i) the delay time ΔT until the switching of the charging states can be recognized and (ii) the minimum cycle period for estimating the battery level. The threshold period is set such that wrong estimation of the battery level is reduced even when the charging states are switched in various ways, based on the slope of the curve of the charge and discharge characteristics (the voltage change amount in unit time). The various ways of switching of the charging state may include a case where the battery level is estimated in the being-charged state, thereafter the charging state is switched to the not-charged state while the estimation of the battery level is paused, and immediately thereafter, charging is resumed and the battery level is estimated, for example.

Further, according to the battery management system 110 of this embodiment, the controller 113 estimates the charging state that includes at least the not-charged state, the charging-completed state, and the being-charged state, based on the charging state information. Further, the controller 113 includes the first table 113c showing the relation between voltages of the secondary battery 102 and multiple ranges of the battery level in the not-charged state and the second table 113d showing the relation between voltages of the secondary battery 102 and multiple ranges of the battery level in the being-charged state. Therefore, in the period in which the charging state is not switched, the controller 113 can accurately estimate the range of the battery level by using the estimated charging state, the first table 113c, and the second table 113d.

Further, the battery management system 110 of this embodiment includes the charging controller 112, the voltage sensor 121, and the controller 113 that receives the charging state information from the charging controller 112 and the voltage value of the secondary battery 102. Based on the charging state information and the voltage value, the controller 113 determines the estimated range of the battery level. When the charging state is unchanged and the voltage has changed across a threshold voltage (e.g., 3.90 V in the being-charged state or 3.75 V in the not-charged state), the controller 113 changes the estimated range from the second level to the third level or vice versa. On the other hand, when the charging state is switched from the being-charged state to the not-charged state or vice versa, the controller 113 does not change the estimated range even if the voltage changes across the threshold voltage, like at the timing t1 in FIG. 5 or the timing t2 in FIG. 6. Therefore, as illustrated in FIG. 5 and FIG. 6, the controller 113 can avoid wrongly determining the estimated range of the battery level.

Although the embodiment of the present disclosure has been described above, the present disclosure is not limited to the above embodiment. For example, the above embodiment is based on a configuration in which a single secondary battery is charged by a single charger as an example. However, the present disclosure may be applied to a configuration in which multiple secondary batteries are charged by multiple chargers and one or more controllers estimate the battery levels of the respective secondary batteries. Further, the secondary battery may be for driving an electric vehicle, and the charger may take in power from a charging station for the vehicle. For another example, the secondary battery may be for driving a smart appliance having a communication function, and the charger may be for charging and managing the secondary battery. Further, a system may be configured such that a device including the secondary battery is different from a device including the charger and that the controller of the system estimates the battery level. The details shown in the embodiment as an example can be appropriately modified without departing from the scope of the invention.

## Claims

1. A battery management system (110) comprising:
a charging controller (112) that controls charging of a secondary battery (102);
a voltage sensor (121) that detects a voltage of the secondary battery; and
a controller (113) that estimates an estimated range to which a battery level of the secondary battery belongs among multiple battery level ranges, wherein:
based on the detected voltage in a charging state among multiple charging states of the charging controller (112), the controller (113) tentatively determines a tentative range to which the battery level belongs among the multiple battery level ranges, and
based on comparison between the tentative range and a past estimated range estimated in a past, the controller (113) estimates a current estimated range that is the estimated range of this time.

2. The battery management system according to claim 1, further comprising a transmission unit (114) that transmits the estimated range outside the battery management system.

3. The battery management system according to claim 1, wherein the controller (113) estimates the estimated range in response to an external request from outside the battery management system.

4. The battery management system according to claim 1, wherein, in response to the charging state being estimated to be a not-charged state and in response to the tentative range being higher than the past estimated range, the controller (113) performs a clip process of determining the current estimated range to be the past estimated range.

5. The battery management system according to claim 1, wherein, in response to the charging state being estimated to be a being-charged state and in response to the tentative range being lower than the past estimated range, the controller (113) performs a clip process of determining the current estimated range to be the past estimated range.

6. The battery management system according to claim 4 or claim 5, wherein the controller (113) does not perform the clip process in response to any of following conditions being satisfied:
(i) the estimated charging state is different from a last charging state,
(ii) a threshold period or longer has elapsed since last determination of the estimated range, or
(iii) the clip process has been consecutively performed by a threshold number of times or more.

7. The battery management system according to claim 1, wherein:
the controller (113) estimates the charging state among the charging states that include at least a not-charged state, a charging-completed state, and a being-charged state,
the controller includes a first table (113c) and a second table (113d), the first table showing a relation between voltages of the secondary battery and the multiple battery level ranges in the not-charged state, the second table showing a relation between voltages of the secondary battery and the multiple battery level ranges in the being-charged state,
in response to the charging state being estimated to be the not-charged state, the controller (113) determines the tentative range, based on the first table, and
in response to the charging state being estimated to be the being-charged state, the controller (113) determines the tentative range, based on the second table.

8. The battery management system according to claim 4 or claim 5, wherein, in response to any of following conditions (i) to (iii) being satisfied, the controller (113) defines the past estimated range to be invalid and does not perform the clip process:
(i) the estimated charging state is different from a last charging state,
(ii) a threshold period or longer has elapsed since last determination of the estimated range, or
(iii) the clip process has been consecutively performed by a predetermined number of times or more.

9. The battery management system according to claim 4, wherein, in response to the charging state being estimated to be the not-charged state and in response to either of following conditions (i) and (ii) being satisfied, the controller (113) determines the tentative range to be the current estimated range and resets a counter value indicating a number of consecutive executions of the clip process:
(i) the past estimated range is invalid, or
(ii) the tentative range is lower than or equal to the past estimated range.

10. The battery management system according to claim 5, wherein, in response to the charging state being estimated to be the being-charged state and in response to either of following conditions (i) and (ii) being satisfied, the controller (113) determines the tentative range to be the current estimated range and resets a counter value indicating a number of consecutive executions of the clip process:
(i) the past estimated range is invalid, or
(ii) the tentative range is higher than or equal to the past estimated range.

11. The battery management system according to claim 4, wherein, in response to the charging state being estimated to be the not-charged state and in response to both of following conditions (i) and (ii) being satisfied, the controller (113) performs the clip process of maintaining the current estimated range at the past estimated range and increments a counter value indicating a number of consecutive executions of the clip process:
(i) the past estimated range is valid, and
(ii) the tentative range is higher than the past estimated range.

12. The battery management system according to claim 5, wherein, in response to the charging state being estimated to be the being-charged state and in response to both of following conditions (i) and (ii) being satisfied, the controller (113) performs the clip process of maintaining the current estimated range at the past estimated range and increments a counter value indicating a number of consecutive executions of the clip process:
(i) the past estimated range is valid, and
(ii) the tentative range is lower than the past estimated range.

13. A battery management system (110) comprising:
a charging controller (112) that controls charging of a secondary battery (102);
a voltage sensor (121) that detects a voltage of the secondary battery; and
a controller (113) that obtains the detected voltage in a charging state among multiple charging states of the charging controller and estimates an estimated range to which a battery level of the secondary battery belongs among multiple battery level ranges, wherein:
when (i) the charging state is unchanged and (ii) the voltage changes across a threshold voltage, the controller (113) changes the estimated range, whereas
when (i) the charging state changes from a not-charged state to a being-charged state or from the being-charged state to the not-charged state and (ii) the voltage changes across the threshold voltage, the controller (113) does not change the estimated range.

14. A battery management method, wherein:
a charging controller (112) controls charging of a secondary battery (102),
a controller (113) different from the charging controller estimates an estimated range to which a battery level of the secondary battery belongs among multiple battery level ranges,
based on a voltage of the secondary battery detected in a charging state among multiple charging states of the charging controller, the controller (113) tentatively determines a tentative range to which the battery level belongs among the multiple battery level ranges, and
based on comparison between the tentative range and a past estimated range estimated in a past, the controller (113) determines a current estimated range that is the estimated range of this time.

15. A program (113b) that causes a computer to estimate an estimated range to which a battery level of a secondary battery (102) belongs among multiple battery level ranges, wherein:
the program causes the computer to tentatively determine a tentative range to which the battery level belongs among the multiple battery level ranges, based on a voltage of the secondary battery detected in a charging state among multiple charging states, and
the program causes the computer to estimate a current estimated range that is the estimated range of this time, based on comparison between the tentative range and a past estimated range estimated in a past.
